# EUROPÄISCHE PATENTSCHRIFT

(11) **EP 0 462 131 B1**
(45) Veröffentlichungstag und Bekanntmachung des Hinweises auf die Patenterteilung: **27.10.1993**
(21) Anmeldenummer: 90903788.9
(22) Anmeldetag: 08.03.1990
(51) Int. Cl.: G01R 33/38, G01R 33/40

(54) **MAGNETSYSTEM**
MAGNET SYSTEM
SYSTEME MAGNETIQUE

(30) Priorität: 11.03.1989 DE 3907927
(43) Veröffentlichungstag der Anmeldung: 27.12.1991
(73) Patentinhaber: BRUKER Analytische Messtechnik GmbH, 76287 Rheinstetten (DE)
(72) Erfinder: LAUKIEN, Günther, D-7512 Rheinstetten 4 (DE); WESTPHAL, Michael, D-6745 Offenbach (DE)
(74) Vertreter: KOHLER SCHMID + PARTNER
(86) Internationale Anmeldenummer: DE9000171
(87) Internationale Veröffentlichungsnummer: WO9010877

(56) Entgegenhaltungen:
- EP-A- 0 111 219
- EP-A- 0 160 350
- EP-A- 0 314 262
- GB-A- 2 158 248
- REVIEW OF SCIENTIFIC INSTRUMENTS, vol. 52, No. 10, October 1981, American Institute of Physics, (New York, US) ; H. Saint-Jalmes et al. : "Optimization of homogeneous electromagnetic coil systems : Application to whole-body NMR imaging magnets"
- REVIEW OF SCIENTIFIC INSTRUMENTS, vol. 56, No. 3, March 1985, American Institute of Physics, (New York, US) ; A.R. Rath et al. : "Opposed coil magnet calculations for large sample and unilateral nuclear-magnetic-resonance"

## Beschreibung

Die Erfindung betrifft ein Magnetsystem zum Erzeugen eines statischen, homogenen magnetischen Feldes im Untersuchungsvolumen eines Kernspintomographen und mit den weiteren, im Oberbegriff des Patentanspruchs 1 genannten, gattungsbestimmenden Merkmalen. Ein solches Magnetsystem ist durch die US-A-4 701 736 bekannt.

Kernspintomographen, ihre Funktionsweise und die möglichen bildgebenden Verfahren sind in der Fachliteratur ausführlich beschrieben (z.B. "Medizinische Physik '83", Hüthig-Verlag, Hrsg. J. Schütz). Eine der Grundkomponenten ist ein Magnetsystem, das in einem möglichst groben und gut zugänglichen Untersuchungsvolumen ein statisches, sehr homogenes Magnetfeld erzeugt. Weitere Anforderungen sind Unempfindlichkeit gegen äußere Störfelder, geringes Streufeld, das Vermeiden von Wirbelströmen im Fall geschalteter magnetischer Gradientenfelder und nicht zuletzt eine einfache und preisgünstige Produktion und Wartung sowie geringe Betriebskosten (Strom, Kühlwasser etc.).

Seit der Entwicklung der ersten Tomographiesysteme in den 70-er Jahren sind eine ganze Reihe unterschiedlicher Magnettypen vorgeschlagen und zum groben Teil auch realisiert worden. Naturgemäß unterscheiden sie sich darin, wie gut sie die einzelnen Anforderungen erfüllen. Von den drei Haupttypen von Magneten, nämlich Permanentmagneten, resistiven Elektromagneten sowie supraleitenden Elektromagneten werden im folgenden nur resistive und supraleitende Systeme betrachtet, da permanentmagnete bei den angestrebten Feldstärken für viele Anwendungen zu schwer und zu instabil sind. Der größte Teil der heutzutage verwendeten Magnetsysteme und praktisch alle supraleitenden Versionen bestehen aus einer langgestreckten, im wesentlichen zylindrischrohrförmigen Spule, die einen kreiszylinderförmigen Innenraum definiert (z.B. DE-A-31 23 493, DE-A-32 45 945). Diese Spule kann aus mehreren Teilsektionen bestehen (z.B. die sog. Doppelhelmholtz-Anordnung, DE-A-32 45 944, EP-A-O 011 335, EP-A-O 033 703 oder Nachr. Chem. Tech. Lab. 28 (1980) Nr. 12, Seite 861-865). Bei den offenen Luftspulen der Doppelhelmholtz-Art ist zwar ein seitlicher Zugang im Prinzip möglich, jedoch stehen die beiden inneren Spulen der Vier-Spulen-Anordnung so nahe zusammen, daß es praktikabler ist, wenn Feld- und Patientenachse übereinstimmen und der Zugang ausschließlich entlang der Spulenachse erfolgt. Bei Magneten mit Kryostaten bzw. Eisenabschirmung in Form eines Zylinders ist dies zwingend. Bei Tomographen für Ganzkörperuntersuchungen am Menschen hat der freie Zugang üblicherweise einen Durchmesser von etwa einem Meter bei einer Gesamtlänge des Systems von deutlich über zwei Metern. Damit befindet sich der Patient bei den gängigen Systemen innerhalb einer langen, verhältnismäßig engen Röhre, was durchaus zu Klaustrophobie führen kann. Zudem ist die Beobachtung des Patienten durch den Arzt oder auch der Zugang im Rahmen weiterer ärztlicher Maßnahmen erschwert. Ähnliches gilt für Magnetsysteme vom "window-frame-Typ" (DE-A-34 18 812). Hier kommt zusätzlich das Problem der groben Eisenmassen dazu, das auch auf die sogenannten H-Magnete (DE-A-36 16 078) zutrifft. Bei diesen Polschuhmagneten mit Eisenjoch ist der freie Zugang wesentlich besser als bei den Solenoidversionen, allerdings sind das hohe Gewicht und im Eisen der Polschuhe induzierte Wirbelströme bzw. die schlecht beherrschbare magnetische Nachwirkung im Fall geschalteter Gradientenfelder von Nachteil. Ein Vorteil ist, daß die Patientenachse auf der Feldachse senkrecht steht (wie auch beim "window-frame") und daß daher als Hochfrequenzsende- und detektorspulen Solenoidspulen eingesetzt werden können, die im Vergleich mit Sattelspulen deutlich empfindlicher sind. Zur Erzeugung des Magnetfeldes sind auch extrem kurze Luftspulen (EP-A-160 350) bekannt geworden bzw. Anordnungen, bei denen der Homogenitäts-und damit Untersuchungsbereich sogar außerhalb der Magnetstruktur liegt (DE-A1-31 40 225). Sie werden jedoch bisher nicht technisch realisiert, erreichen wohl in der Praxis auch nicht die an die NMR-Tomographie gestellten Anforderungen.

Ferner ist aus Review of Scientific Instruments 56, 1985, Seiten 402-410, eine sogenannte "Quasi-Helmholtz"-Anordnung bekannt, die aus zwei axial beabstandeten Spulenpaaren mit je einer radial inneren und einer radial äußeren Spule besteht, wobei die radial inneren und die radial äußeren Spulen als langgestreckte Solenoide ausgebildet sind und von gegenläufigen Strömen durchflossen werden. Bei dieser Anordnung kann der Abstand der Spulenpaare bei gleicher Ausdehnung des homogenen Feldbereichs größer gewählt werden als der Abstand der Spulen in einer Helmholtz-Anordnung mit gleichem Außenradius.

Aufgabe der Erfindung ist es daher, ein Magnetsystem für den Einsatz in der NMR-Tomographie bereitzustellen, das in Relation zu der Größe des Untersuchungsvolumens, in welchem ein weitgehend homogenes Magnetfeld erzeugt werden muß, mit vergleichsweise geringen axialen und radialen Abmessungen sowie verhältnismäßig geringem Gesamtgewicht realisierbar ist, das die Möglichkeit des Zuganges zu dem Untersuchungsvolumen aus mehreren verschiedenen Richtungen bietet und darüberhinaus auch weitgehend unanfällig gegen Wirbelstromeffekte ist, die z.B. durch Gradientenschalten bedingt sind.

Diese Aufgabe wird erfindungsgemäß durch die Merkmale des Patentanspruchs 1 gelöst. Hiernach werden zwei Feldspulenpaare aus jeweils identischen Spulen für das Magnetsystem verwendet, die symmetrisch zu einer senkrecht zur Feldachse durch das Zentrum der Anordnung verlaufenden Mittelebene angeordnet sind, wobei auf beiden Seiten dieser Mittelebene jeweils eine radial äußere und eine mit dieser koaxiale radial innere Spule vorhanden sind. Beide Spulen befinden sich im wesentlichen in der gleichen Ebene, d.h. bei Spulen endlicher Länge gibt es Windungen in beiden Spulen, die den gleichen axialen Abstand vom Zentrum haben. Die inneren und die äußeren Spulen sind so verschaltet, daß sie von gegenläufigen Strömen durchflossen werden. Im Gegensatz zur bekannten Doppelhelmholtzanordnung (Garrett, J. Appl. Phys. 38, 1967, No. 6, S. 2563 und J. Appl. Phys. 22, 1951, No. 9, S. 1091) kann hierbei der geringste auftretende axiale Abstand zum Zentrum wesentlich größer gewählt werden. Damit wird ein Zugang sowohl axial als auch in der Mittelebene radial (das ist transversal) möglich.

Durch geeignete Wahl der Abstände und Spulendimensionen kann so ein Spulensystem 8. Ordnung erreicht werden, d.h. im Zentrum verschwinden alle Ableitungen des Magnetfeldes nach den Raumkoordinaten bis zum 7. Grad einschließlich. Die Doppelhelmholtzanordnung stellt ein solches System 8. Ordnung dar.

Die Erfindung ist jedoch nicht auf ein Spulensystem beschränkt, das exakt die 8. Ordnung hat. Es ist vielmehr möglich, die Spulen des Spulensystems etwas weiter auseinander zu rücken als zur Erzielung der 8. Ordnung erforderlich ist, und dadurch die Gestalt des Homogenitätsvolumens gegenüber der Kugelform zu verformen, wobei man eine gewisse Restwelligkeit in Kauf nimmt, so daß in dem sich dann ergebenden Homogenitätsvolumen die Grenze des Homogenitätsvolumens mit einer Abweichung von z.B. 20 ppm nicht in nur einer Richtung der Abweichung vorliegt (z.B. nicht nur minus 20 ppm), sondern nach beiden Richtungen, also ± 20 ppm. Auch derartige Systeme, die weitgehend der 8. Ordnung genügen und die daher hier als Systeme quasi 8. Ordnung bezeichnet werden, sollen zur Erfindung gehören. Es versteht sich, daß auch ein System 12. Ordnung zur Erfindung gehört, denn ein System 12. Ordnung ist gleichzeitig ein System 8. Ordnung.

Aufgrund der gegenläufigen Ströme ist bei gegebener Gesamtwicklungslänge die erreichbare Feldstärke im Zentrum nicht so hoch wie bei konventionellen Systemen 8. Ordnung (solenoidartig). Das kann jedoch insbesondere bei supraleitenden Magneten in Kauf genommen werden, besonders wenn man die erhöhte HF-Empfindlichkeit berücksichtigt. Der Vorteil des weit besseren Zugangs bei gleicher Homogenität wiegt die geringere Feldstärke auf.

Das erfindungsgemäße System kann sowohl resistiv als auch supraleitend realisiert werden. Im supraleitenden Fall befinden sich die Spulen im Inneren eines Kryostaten, der mindestens zwei senkrecht aufeinanderstehende Zimmertemperaturzugänge zum Feldzentrum und damit zum Untersuchungsvolumen hat. Diese können axial und/oder radial sein. Im einfachsten Fall ist der Kryostat von einer axialen und einer radialen Raumtemperaturbohrung durchsetzt, die sich im Zentrum schneiden. Es können auch insgesamt drei Bohrungen sein (1 axial, 2 radial) oder eine Bohrung muß nicht durchgehend sein. Kryostaten mit mindestens einem transversalen Zimmertemperaturzugang sind technisch aufwendiger, aber grundsätzlich bekannt.

Um Probleme beim sicheren Abfangen der magnetischen Kräfte zwischen den Teilspulen zu vermeiden, ist es vorteilhaft, innerhalb eines Kryostaten nur einen durchgehenden Spulenträger (Edelstahl oder Aluminium) zu verwenden, obwohl die Struktur mit dem weiten axialen Abstand die Verwendung zweier getrennter Kryostatensysteme erlaubt.

Unabhängig von den Merkmalen des kennzeichnenden Teils des Anspruchs 1 wird eine Erfindung auch darin gesehen, daß der Homogenitätsbereich mit einer Abweichung von maximal ± 20 ppm einen Durchmesser von mindestens 40% des jeweils kleineren axialen Abstands g₂ oder g₁ des radial inneren bzw. äußeren Spulenpaares hat. Insbesondere kann es vorteilhaft sein, den genannten Homogenitätsbereich auf mindestens 50% des genannten Maßes zu vergrößern.

Weitere Einzelheiten und Merkmale der Erfindung ergeben sich aus der nachfolgenden Beschreibung bevorzugter Ausführungsbeispiele anhand der Zeichnung. Es zeigen:
- Fig. 1: ein erfindungsgemäßes Magnetsystem in vereinfachter, schematischer Schnittdarstellung in einer die zentrale Längsachse des Magnetsystems enthaltendene Radialebene,
- Fig. 2a: eine perspektivische Ansicht eines Kryostaten für ein supraleitendes Magnetsystem gemäß Fig. 1, mit horizontal verlaufender zentraler Längsachse,
- Fig. 2b: den Kryostaten gemäß Fig. 1 im Schnitt längs der vertikalen Längsmittelebene des Kryostaten gemäß Fig. 2a,
- Fig. 3a: einen Kryostaten für ein supraleitendes Magnetsystem gemäß Fig. 1, jedoch mit vertikalem Verlauf dessen zentraler Längsachse,
- Fig. 3b: den Kryostaten gemäß Fig. 3a im Schnitt längs einer dessen zentrale Achse enthaltenden Ebene, welche rechtwinklig zu einer transversalen Zugangsöffnung verläuft.

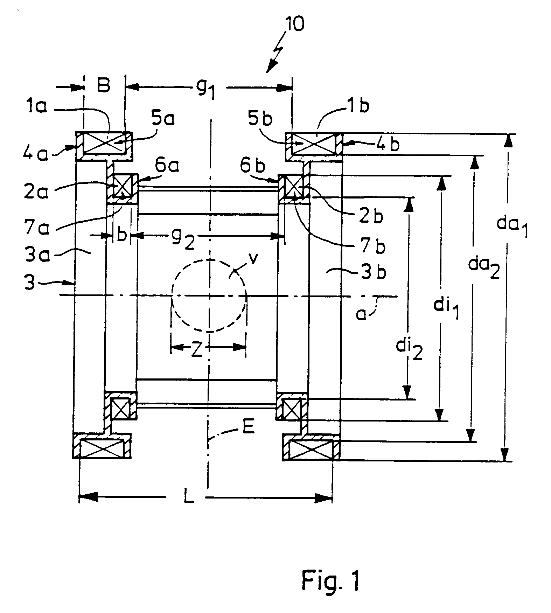

Das in der Fig. 1, auf deren Einzelheiten ausdrücklich verwiesen sei, dargestellte erfindungsgemäße Magnetsystem 10 umfaßt ein radial äußeres Paar von Wicklungen bzw. Feldspulen 1a und 1b sowie ein radial inneres Paar von Wicklungen bzw. Feldspulen 2a und 2b, welche entlang einer gemeinsamen zentralen Achse a koaxial und bezüglich einer zentralen Quermittelebene E, welche rechtwinklig zu der zentralen Achse a verläuft, insgesamt symmetrisch angeordnet sind. Die äußeren Wicklungen 1a und 1b sowie die inneren Wicklungen 2a und 2b sind auf einen insgesamt mit 3 bezeichneten Spulenkörper aufgewickelt, welcher zwei Tragringe 3a und 3b umfaßt, welche die jeweils einseitig von der Quermittelebene E angeordnete äußere und innere Wicklung 1a und 2a bzw. lb und 2b tragen. Diese Tragringe 3a und 3b des Spulenkörpers 3 haben je ein äußeres, gemäß der Darstellung der Fig. 1 nach außen offenes, durch rechtwinklig aneinander anschließende Profilschenkel begrenztes U-Profil 4a bzw. 4b, durch deren in axialer Richtung gemessene lichte Breite B und durch deren in radialer Richtung gemessene Tiefe (dₐ₁-dₐ₂)/2 die rechteckige Querschnittsfläche von Wickelkammern 5a bzw. 5b bestimmt ist, die von den Windungen der äußeren Feldspulen 1a bzw. 1b in dichtestmöglicher Packung eingenommen werden, wobei mit dₐ₁ der Außendurchmesser und dₐ₂ der Innendurchmesser der äußeren Wicklungen 1a bzw. 1b bezeichnet sind.

Des weiteren haben die Tragringe 3a und 3b je ein inneres, gemäß der Darstellung der Fig. 1 ebenfalls nach außen offenes, durch rechtwinklig aneinander anschließende Profilschenkel begrenztes U-Profil 6a bzw. 6b, durch deren in axialer Richtung gemessene lichte Breite b und deren in radialer Richtung gemessene Tiefe (dᵢ₁-dᵢ₂)/2 die - ebenfalls rechteckige - Querschnittsfläche von Wickelkammern 7a bzw. 7b bestimmt ist, die von den Wicklungen der inneren Feldspulen 2a bzw. 2b - in dichtestmöglicher Packung - eingenommen wird, wobei mit dᵢ₁ der Außendurchmesser und dᵢ₂ der Innendurchmesser der inneren Wicklungen 2a bzw. 2b bezeichnet sind. Die Tragringe 3a und 3b der beiden Teilspulenpaare werden zweckmäßig aus separaten Teilringen 3a₁ und 3a₂ bzw. 3b₁ und 3b₂ zur Aufnahme je einer Wicklung 1a und 2a bzw. 1b und 2b gebildet. Nach dem Wickeln der Wicklungen werden die Teilringe zu je einem Tragring 3a bzw. 3b zusammengebaut und fest miteinander verbunden. Die solchermaßen gebildeten Tragringe 3a und 3b werden ihrerseits durch Längsbalken 8 fest miteinander verbunden, wobei, wie nicht eigens dargestellt, der axiale Abstand der Tragringe 3a und 3b justierbar ist. Beim dargestellten, bevorzugten Ausführungsbeispiel umfaßt der Spulenkörper 3 vier solcher Längsbalken, die symmetrisch zu der durch die Zeichenebene markierten und auch symmetrisch zu der senkrecht zur Zeichenebene verlaufenden, die zentrale Achse a des Magnetsystems 10 enthaltenden Längsmittelebene angeordnet sind und dabei, entlang der senkrechten Achse gesehen, in gleichen Winkelabständen - axialsymmetrisch - um die Achse a gruppiert sein können. Durch die Balken 8 werden die axialen Kräfte aufgefangen, welche die Wicklungen 1a und 1b sowie 2a und 2b im stromdurchflossenen Zustand des Magnetsystems aufeinander ausüben. Der axiale Abstand g₁, in dem die äußeren Wicklungen 1a und 1b voreinander angeordnet sind, kann bei dem Magnetsystem 10 zwischen 40% und 60% des inneren Spulendurchmessers dₐ₂ der äußeren Feldspulen 1a bzw. 1b variieren, wobei ein bevorzugter Wert dieses Abstandes g₁ bei etwa der Hälfte dieses inneren Spulendurchmessers dₐ₂ liegt. Es liegen die Schwerpunkte der Querschnitte der Wicklungen 1a und 1b (axial (g₁ + B)/2, radial (dₐ₁ + dₐ₂)/2) axial weiter auseinander als bei einer Helmholtz-Anordnung dieses Wicklungspaars.

Das innere Spulenpaar 2a, 2b ist hinsichtlich seiner charakteristischen Abmessungen - Außendurchmesser dᵢ₁ und Innendurchmesser dᵢ₂ - kleiner als das äußere Spulenpaar 1a, 1b, wobei seine Wicklungsdichte dem Betrag nach derjenigen des äußeren Spulenpaares gleich ist. Bei Bedarf kann die Wicklungsdichte abweichend gewählt werden.

Der axiale Abstand g₂ der inneren Wicklungen 2a und 2b ist mit einer Abweichung von maximal 15% gleich dem axialen Abstand g₁ der äußeren Wicklungen 1a und 1b und beim dargestellten, speziellen Ausführungsbeipiel geringfügig kleiner als der axiale Abstand g₁ der äußeren Wicklungen 1a und 1b, so daß die axiale lichte Weite zwischen den beiden Wicklungen 2a und 2b ähnlich derjenigen zwischen den beiden äußeren Wicklungen 1a und 1b ist.

Der im Betrieb des Magnetsystems 1 durch das innere Paar von Wicklungen 2a, 2b fließende Strom ist, der Richtung nach, demjenigen entgegengesetzt, der durch das äußere Paar 1a, 1b fließt, so daß die von den beiden Wicklungspaaren 1a, 1b und 2a, 2b erzeugten Magnetfelder einander entgegengesetzt sind, wobei die Windungszahlen der äußeren Wicklungen 1a und 1b zu den Windungszahlen der inneren Wicklungen 2a und 2b - die gleiche Stromstärke in den Wicklungen 1a und 1b sowie 2a, 2b vorausgesetzt - im Verhältnis von etwa 4/1 zueinander stehen, wobei dieses Verhältnis innerhalb einer Marge von ± 20% variieren kann.

Durch geeignete Wahl der Stärke der Ströme, welche durch die beiden Wicklungspaare 1a, 1b sowie 2a, 2b fließen, läßt sich ein statisches Magnetfeld erzeugen, das innerhalb des in der Fig. 1 gestrichelt angedeuteten, kreisförmigen umrandeten Untersuchungsvolumens V, dessen Durchmesser mit Z bezeichnet ist, hinreichend homogen ist, wobei dieser Durchmesser z zirka 40 cm beträgt (Feldabweichung 20 ppm).

In einer bevorzugten Gestaltung des Magnetsystems 1 mit supraleitenden Magnetspulen beträgt der axiale Abstand g₁ des äußeren Wicklungspaares 1a, 1b 790 mm und die axiale Breite B der Wickelkammern 200 mm. Die zwischen den Außenwänden der Wickelkammern 5a und 5b gemessene axiale Ausdehnung L des Magnetsystems 10 beträgt 1190 mm. Der Innendurchmesser dₐ₂ der äußeren Wickelkammern 5a und 5b beträgt 1612 mm und der Außendurchmesser dₐ₁ der äußeren Wicklungen 1a und 1b 1802 mm. Die Windungsdichte in den äußeren Wickelkammern 5a und 5b beträgt 36,80 Windungen/cm².

Bei dem inneren Wicklungspaar 2a, 2b beträgt der axiale Abstand g2 seiner Wickelkammern 7a und 7b 757,6 mm, wobei die axiale Breite b dieser Wickelkammern 7a und 7b jeweils 54,5 mm beträgt. Der Innendurchmesser dᵢ₂ der Wicklungen 2a und 2b hat einen Wert von 1220 mm, während der Außendurchmesser dᵢ₁ der inneren Wicklungen 2a und 2b einen Wert von 1378 mm hat. Die Windungsdichte der inneren Wicklungen 2a und 2b ist derjenigen der äußeren Wicklungen 1a und 1b entgegengesetzt gleich und hat demgemäß den Wert -36,8. Bei dem genannten Abstand g₂ der Wickelkammern 7a und 7b des inneren Spulenpaares 2a und 2b entsteht ein nutzbarer Zwischenraum z von 60 cm.

Bei einer Stromstärke von 157 A ergibt sich ein homogenes Magnetfeld im Zentrum des Magnetsystems 10 von 0,7 Tesla.

Bei den oben genannten Abmessungen beträgt das Gewicht der vier Wicklungen einschließlich des Spulenträgers etwa 2 Tonnen. Davon entfallen etwa drei Viertel auf die Supraleiter-Kupferwindungen und ein Viertel auf den Spulenträger. Dieses Gewicht ist vergleichsweise gering, weil keine groben Eisenmassen zur Führung des Magnetfeldes erforderlich sind. Aus demselben Grund sind, im Falle geschalteter Gradientenfelder, die magnetische Nachwirkung und die Induktion von Wirbelströmen gering.

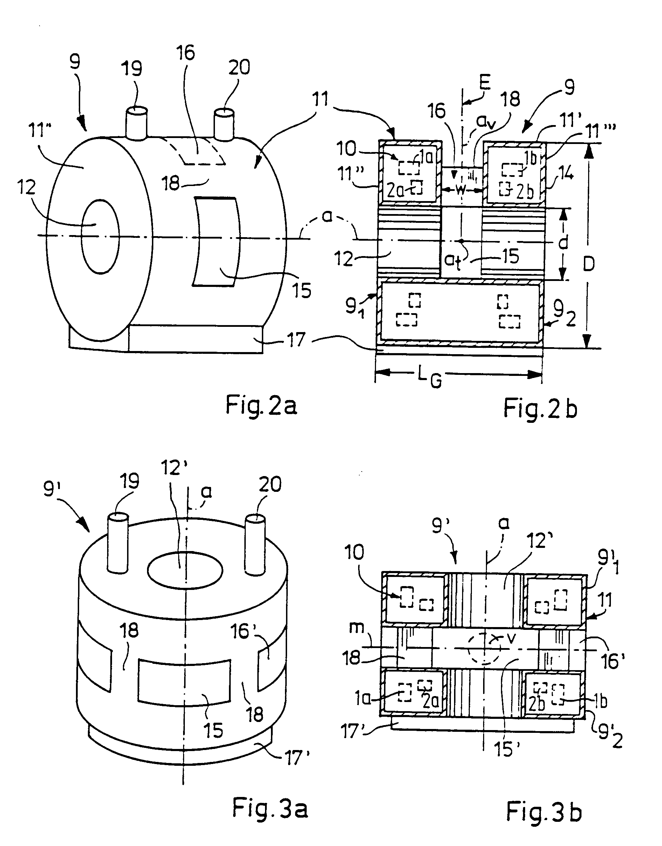

Anhand der Figuren 2a und 2b, auf deren Einzelheiten ausdrücklich verwiesen sei, wird nunmehr eine erste, bevorzugte Gestaltung eines Kryostaten 9 erläutert, der ein Magnetsystem 10, wie anhand der Fig. 1 seinem grundsätzlichem Aufbau nach beschrieben, enthält, welches in dem Kryostaten 9 soweit abkühlbar ist, daß die Wicklungen 1a und 1b sowie 2a und 2b in den supraleitenden Zustand gelangen, wobei der Kryostat 9 hinsichtlich seines kryotechnischen Aufbaues mit Tanks für flüssiges Helium und flüssigen Stickstoff, Strahlungsschildern und evakuierbaren Kammern, deren Anordnung nicht dargestellt ist, als für sich bekannt vorausgesetzt wird, so daß sich diesbezügliche Erläuterungen erübrigen. Dargestellt ist lediglich der insgesamt mit 11 bezeichnete, auf Raumtemperatur befindliche Außenmantel des Kryostaten 9.

Die den Kryostaten 9 in Richtung seiner zentralen Achse a durchsetzende zylinderförmige, zentrale Öffnung 12 hat einen typischen nutzbaren Innendurchmesser von 100 cm. Der Außendurchmesser des Kryostatenmantels hat einen typischen Wert von 200 cm.

Die zwischen den kreisringförmigen Endstirnflächen 13 und 14 des Mantels 11 des Kryostaten 9 gemessene Gesamtlänge L_{G} desselben hat einen typischen Wert von 150 cm.

Der Mantel 11 des Kryostaten 9 hat zusätzlich zu der zentralen, axialen Öffnung 12 auch eine transversal durchgehende Öffnung 15, deren zentrale Achse aₜ die zentrale Längesachse a des Kryostaten 9 bzw. des Magnetsystems 10 rechtwinklig schneidet. Diese transversale Öffnung 15 hat, parallel zur zentralen Längsachse a des Kryostaten 9 gemessen, eine lichte Weite mit einem typischen Wert von 60 cm und, senkrecht dazu gemessen, eine dem Innendurchmesser d der zentralen Längsöffnung 12 entsprechende lichte Höhe.

Bei dem Ausführungsbeispiel gemäß den Figuren 2a und 2b ist der Kryostat 9 liegend angeordnet, d.h. die durch die beiden zentralen Längsachsen a und aₜ der beiden Öffnungen 12 und 15 markierte Ebene verläuft horizontal. Die transversale Öffnung 15 ist sowohl symmetrisch bezüglich der durch die beiden Achsen a und aₜ markierten Ebene als auch symmetrisch zu der Quermittelebene E des Kryostaten 9 ausgebildet.

Der insoweit erläuterte Kryostat 9 bietet die Möglichkeit, einen Patienten, der einer NMR-tomographischen Untersuchung unterworfen werden soll, entweder in die axial verlaufende, zentrale Öffnung 12 einzubringen, in welchem Fall das von dem Magnetsystem 10 erzeugte Magnetfeld parallel zur Körperlängsachse des Patienten gerichtet ist, oder diesen in die transversale Öffnung 15 einzubringen, in welchem Falle das Magnetfeld transversal zu der Längsachse des Patienten gerichtet ist. In beiden Lagen beträgt die - axiale - Ausdehnung z des für die tomographische Untersuchung ausnutzbaren Raumes mit hoher Feldhomogenität etwa 40 cm.

In der Fig. 2a ist gestrichelt, in der Fig. 2b in ausgezogenen Linien eine nach oben offene, transversale Öffnung 16 dargestellt, deren axiale lichte Weite w derjenigen der horizontalen transversalen Öffnung 15 entspricht und deren senkrecht zur Zeichenebene gemessene, transversale lichte Weite wiederum dem Durchmesser der axialen Durchgangsöffnung 12 entspricht. Diese weitere transversale Öffnung 16, deren - vertikale - zentrale Achse aᵥ durch den Schnittpunkt der zentralen Achsen a und aₜ der beiden anderen durchgehenden Öffnungen 12 und 15 verläuft, ist in spezieller Gestaltung des Kryostaten 9 so ausgebildet, daß sie lediglich von oben her in die zentrale, axiale Öffnung 12 mündet, diese aber nicht durchquert. Sie kann aber auch als durchgehende Öffnung ausgebildet sein, um insoweit insgesamt einen möglichst symmetrischen Aufbau des Kryostaten 9 und seines Mantels 11 zu erzielen. Die vertikale Öffnung 16 ist dann an ihrer Unterseite durch den Sockel 17 des Kryostaten 9 abgeschlossen. Die vertikale Öffnung 16 kann alternativ oder zusätzlich zu einer der horizontalen Öffnungen 12 oder 15 vorgesehen sein.

Zusätzlich zu dem Vorteil, der daraus resultiert, daß das Magnetfeld senkrecht zur Körperlängsachse des Patienten gerichtet ist, ist die Ausnutzung der transversalen Öffnung 15 des Kryostaten 9 zur Einbringung des Patienten in den Untersuchungsraum auch besonders vorteilhaft, wenn man an den Körper des Patienten, von oben oder von unten her, Oberflächenspulen - z.B. Empfängerspulen - anlegt, da bei dieser Konfiguration der beste Zugang zu inneren Organen bzw. zur Wirbelsäule des Patienten gegeben ist und das durch die Oberflächenspulen erzeugte HF-Feld sehr gut senkrecht zur Feldrichtung des statischen Magnetfeldes gerichtet ist, das von dem Magnetsystem 10 erzeugt wird.

Die in den Fig. 3a und 3b, auf deren Einzelheiten nunmehr verwiesen sei, dargestellte, weitere Gestaltung eines ein erfindungsgemäßes Magnetsystem 10 enthaltenden Kryostaten 9' für einen Ganzkörper-NMR-Tomographen unterscheidet sich von der anhand der Figuren 2a und 2b geschilderten im wesentlichen nur dadurch, daß der Kryostat 9' stehend angeordnet ist, das heißt, mit vertikalem Verlauf der zentralen Achse a, zu der das Magnetfeld im Untersuchungsvolumen parallel gerichtet ist.

Bei dem Ausführungsbeispiel gemäß den Fig. 3a und 3b ist eine optimale Zugänglichkeit des Untersuchungsvolumens dadurch gegeben, daß zusätzlich zu der sich hier in vertikaler Richtung erstreckenden axialen Öffnung 12' zwei durchgehende, transversale Öffnungen 15' und 16' vorgesehen sind, deren zentrale Achsen sich im Zentrum des Untersuchungsvolumens rechtwinklig schneiden. Das in der Fig. 3b durch einen gestrichelt eingezeichneten Kreis schematisch markierte Untersuchungsvolumen V ist somit von oben her sowie über vier transversale Öffnungen von der Seite her zugängig, deren gemeinsame Mittelebene m horizontal verläuft. Die vertikale zentrale Öffnung 12' ist hier als eine sich über die gesamte Höhe des Kryostatenmantels 11 erstreckende, durchgehende Öffnung ausgebildet, die an der Unterseite durch eine Bodenplatte 17' abgeschlossen ist, welche gleichzeitig den Standsockel des Kryostaten 9' bildet. Auch beim Ausführungsbeispiel gemäß den Fig. 3a und 3b könnte die vertikale Zugangsöffnung 12', alternativ so ausgebildet sein, daß sie lediglich in die transversale(n) Öffnung(en) 15' und/oder 16' von oben her einmündet. Die so entstandene Gesamtanordnung läßt sich als im wesentlichen aus zwei horizontal angeordneten Scheibenkryostaten 9'₁ sowie 9'₂ bestehend charakterisieren, die durch insgesamt vier Säulen - oder balkenförmige Elemente - 18 des Kryostaten 9' miteinander verbunden sind.

Die beiden Scheibenkryostaten 9'₁ sowie 9'₂ bilden jedoch kryotechnisch eine Einheit, wobei die kommunizierende Verbindung der - nicht im einzelnen dargestellten - evakuierten Räume und die kryogene Flüssigkeiten enthaltenden Kammern über die balkenförmigen Verbindungselemente kommunizierend miteinander verbunden sind. Über die balkenförmigen Elemente 18 sind auch die beiden Teilspulenpaare 1a und 1b sowie 2a und 2b starr miteinander verbunden. Die anhand der Fig. 3a und 3b erläuterte Bauform ist vorteilhaft, wenn die lichte Weite der senkrechten Öffnung 12' größer sein soll als die lichte Höhe der horizontalen Öffnung 15' und 16'.

In entsprechender Weise kann auch der liegend angeordnete Kryostat gemäß den Fig. 2a und 2b als aus zwei vertikalen Scheibenkryostaten 9₁ und 9₂ bestehend charakterisiert werden, welche kryotechnisch ebenfalls über - hier horizontale - Balkenelemente 18, eine kryotechnische Einheit bildend, miteinander verbunden sind, so daß für verschiedene kryogene Flüssigkeiten - flüssiges Helium und flüssiger Stickstoff - jeweils nur ein Einfüllstutzen 19 bzw. 20 vorgesehen werden muß.

In weiteren, bevorzugten Ausgestaltungen ist zur Rückführung des magnetischen Flusses eine Eisenabschirmung vorgesehen, die das Magnetsystem 10 im wesentlichen zylindrisch umgibt. Der Form nach kann diese Eisenabschirmung, welche der Einfachheit halber nicht eigens dargestellt ist, der radial äußeren Haut 11' des Kryostatenmantels 11 einschließlich der äußeren Ringstirnflächen 11'' und 11''' entsprechen, wobei, um den transversalen Zugang zu gestatten, auch diese Abschirmung an den jeweils vorhandenen Zugangsöffnungen unterbrochen ist oder, ähnlich wie in der EP-A0 141 146 beschrieben, aus im wesentlichen vier oder mehr balkenartigen Abschirmelementen besteht, die parallel zur zentralen Achse a verlaufen und die transversalen Zugangsöffnungen freilassen.

Es versteht sich, daß die im Stand der Technik bekannten Maßnahmen und Modifikationen, auf die hier nicht eigens eingegangen wird, wie Justierbarkeit, Berücksichtigung des Eisens bei der Feldberechnung und Spulenauslegung, mechanische Abstützung, Lamellierung der Eisenteile, Verwendung von Eisenteilen zum Homogenisieren des Feldes u.s.w. ebenfalls integriert werden können. Auch sind diese Maßnahmen sowohl bei resistiven wie bei supraleitenden Magnetsystemen möglich.

In vorteilhafter Weise wird das an sich im Stand der Technik für solenoidartige Ganzkörpertomographen bekannte Shimspulen- bzw. Gradienten-System dahingehend verändert, daß an der Stelle des transversalen Zuganges eine freie Lücke von mindestens etwa 60 cm verbleibt. Dies ist durchaus möglich, da die Korrektur- bzw. Gradientenspulen nicht auf einen festen Radius beschränkt sein müssen.

Einen oder zwei senkrecht aufeinanderstehende, vollkommen freie transversale Zugänge behält man, wenn man die seit langer Zeit aus dem Bereich der Polschuhmagnete bekannten Shim- bzw. Gradientenplattenanordnungen verwendet, allerdings im allgemeinen auf Kosten eines eingeschränkten axialen Zugangs.

Bei medizinischen Ganzkörper-Tomographen können die zur Körperlängsachse eines Patienten rechtwinkligen Zugänge vorteilhaft zur Kommunikation bzw. zur Beobachtung des Patienten oder auch zum Anbringen weiterer Therapie-, Überwachungs- und Diagnoseapparate genutzt werden.

Durch die Erfindung ergibt sich eine Vielfalt von Möglichkeiten, um die Zugänglichkeit des Untersuchungsvolumens zu verbessern und NMR-Tomographen für Ganzkörperuntersuchung gezielter auszunutzen. Auch wird durch die Erfindung die Wechselwirkung des statischen Magnetfeldes mit den geschalteten Gradientenfeldern verringert.

Zur weiteren Homogenitätssteigerung können bei Bedarf noch weitere Spulen vorgesehen werden, wodurch ein Spulensystem einer noch höheren Ordnung geschaffen werden kann.

## Patentansprüche

1. Magnetsystem zum Erzeugen eines statischen, homogenen Magnetfeldes im Untersuchungsvolumen eines Kernspintomographen, mit einem Paar untereinander gleicher radial äußerer Feldspulen (1a, 1b), die auf einer gemeinsamen Achse (a) mit einem axialen Abstand (g₁) zueinander angeordnet sind, sowie mit einem Paar radial innerer, mit den äußeren Feldspulen koaxialer Feldspulen (2a, 2b), die ebenfalls untereinander gleich sind, wobei beide Spulenpaare symmetrisch zu einer zentralen, zur gemeinsamen Achse (a) senkrecht verlaufenden Mittelebene (E) angeordnet sind und im Betrieb des Magnetsystems (10) die Stromrichtung in den inneren Feldspulen (2a und 2b) zu derjenigen in den äußeren Feldspulen (1a und 1b) entgegengesetzt gerichtet ist, mit mindestens einer zum Untersuchungsvolumen führenden Zugangsöffnung, dadurch gekennzeichnet, daß der axiale Abstand (g₁) der äußeren Feldspulen (1a und 1b) 40% bis 60% des Innendurchmessers (dₐ₂) der äußeren Feldspulen (1a und 1b) beträgt, daß der axiale Abstand (g₂) der inneren Feldspulen (2a und 2b) mit einer Abweichung von maximal 15% gleich dem axialen Abstand (g1) der äußeren Feldspulen (1a und 1b) ist, daß das Magnetsystem ein Spulensystem zumindest weitgehend achter Ordnung bildet, und daß mindestens eine radiale Zugangsöffnung, die sich quer zur Richtung des homogenen Magnetfeldes erstreckt und zwischen den inneren Feldspulen (2a, 2b) verläuft, vorgesehen ist.

2. Magnetsystem nach Anspruch 1, gekennzeichnet durch eine axiale Zugangsöffnung, die sich in Richtung des homogenen Magnetfeldes erstreckt.

3. Magnetsystem nach einem der vorhergehenden Ansprüche, dadurch gekennzeichnet, daß zur Rückführung des Magnetflusses eine das Feldspulensystem (1a, 1b, 2a, 2b) außenseitig, in Umfangsrichtung gesehen mindestens abschnittsweise umgebende Eisenabschirmung vorgesehen ist, daß die Eisenabschirmung einen das Spulensystem (1a, 1b, 2a, 2b) umgebenden rohrförmigen Mantelkörper aufweist, und daß der Mantelkörper mindestens eine Aussparung hat, deren parallel zur zentralen Achse (a) gemessene longitudinale und rechtwinklig dazu gemessene azimutale lichte Weite durch die entsprechenden Abmessungen einer transversalen Zugangsöffnung des Magnetsystems (10) bestimmt sind.

4. Magnetsystem nach Anspruch 3, dadurch gekennzeichnet, daß die Eisenabschirmung parallel zur zentralen Achse (a) des Spulensystems (1a, 1b, 2a, 2b) sich erstreckende balkenförmige Abschirmelemente umfaßt, deren in Umfangsrichtung gemessener Abstand durch die Öffnungsweite transversaler Zugangsöffnungen bestimmt ist.

5. Magnetsystem nach Anspruch 3 oder 4, dadurch gekennzeichnet, daß die Eisenabschirmung ringscheibenförmige Endstirnwände hat.

6. Magnetsystem nach Anspruch 3 oder 4, dadurch gekennzeichnet, daß die Eisenabschirmung geschlossene Endplatten aufweist.

7. Magnetsystem nach einem der vorhergehenden Ansprüche 1 bis 6 für einen Ganzkörper-Kernspintomographen, mit einem Shim- und Gradientensystem zur Erzeugung von magnetischen Korrektur- und Gradientenfeldern in drei orthogonalen Raumrichtungen, dadurch gekennzeichnet, daß die in Feldlängsrichtung gemessene Öffnungsweite einer in das Untersuchungsvolumen (V) mündenden transversalen Zugangsöffnung mindestens 45 cm beträgt.

8. Magnetsystem nach Anspruch 7, dadurch gekennzeichnet, daß mindestens eine zur Körperachse des Patienten transversal verlaufende Zugangsöffnung vorgesehen ist, welche für die Anordnung oder die Durchführung von Mitteln für die Überwachung, Diagnose oder Therapie des Patienten oder zur Kommunikation mit dem Patienten ausnutzbar ist.

9. Magnetsystem nach einem der vorhergehenden Ansprüche, dadurch gekennzeichnet, daß der Homogenitätsbereich mit einer Feldabweichung von maximal ± 20 ppm einen Durchmesser von mindestens 40% des jeweils kleineren axialen Abstands g₂ oder g₁ (g₂) des inneren (2a, 2b) bzw. äußeren Spulenpaares hat.

10. Magnetsystem nach Anspruch 9, dadurch gekennzeichnet, daß der Homogenitätsbereich einen Durchmesser von mindestens 50% des genannten Maßes hat.

## Claims

1. Magnet system for the production of a static homogeneous magnetic field in an investigational volume of a nuclear spin tomograph with a pair of mutually similar radially outer field coils (1a, 1b) which are arranged along a common axis (a) at an axial separation (g₁) with respect to each other as well as with a pair of radially inner likewise mutually similar field coils (2a, 2b) which are coaxial to the outer field coils, whereby both coil pairs are arranged symmetrically to a central middle plane (E) running perpendicularly to the common axis (a), and during operation of the magnet system (10), the current direction in the inner field coils (2a and 2b) is directed oppositely to that in the outer field coils (1a and 1b), with at least one access opening leading to the investigational volume, characterized in that the axial separation (g₁) of the outer field coils (1a and 1b) assumes a value of 40 % to 60 % of the inner diameter (dₐ₂) of the outer field coils (1a and 1b), that the axial separation (g₂) of the inner field coils (2a and 2b) is equal, to within a deviation of at most 15 %, to the axial separation (g₁) of the outer field coils (1a and 1b), that the magnet system is a coil system of at least essentially 8th order, and in that at least one radial access opening is provided for which extends transverse to the direction of the homogeneous magnetic field between the inner field coils (2a, 2b).

2. Magnet system according to claim 1, characterized in that an axial access opening runs in the direction of the homogeneous magnetic field.

3. Magnet system according to one of the preceeding claims, characterized in that an iron shielding is provided for outside of and, as viewed circumferentially, at least sectionwise surrounding the field coil system (1a, 1b, 2a, 2b) for return of the magnetic flux, in that the iron shielding exhibits a pipe shaped jacket body surrounding the coil system (1a, 1b, 2a, 2b) and in that the jacket body has at least one opening whose, measured parallel to the central axis (a), longitudinal clearance and whose, measured at right angles thereto, azimuthal clearance is determined by the corresponding dimensions of a transverse access opening of the magnet system (10).

4. Magnet system according to claim 3, characterized in that the iron shielding includes extended strut-shaped shielding elements parallel to the central axis (a) of the coil system (1a, 1b, 2a, 2b) whose circumferential separation is determined by the opening sizes of the transverse access openings.

5. Magnet system according to claims 3 or 4, characterized in that the iron shielding has ring shaped end face plates.

6. Magnet system according to claims 3 or 4, characterized in that the iron shielding exhibits closed end plates.

7. Magnet system according to one of the preceding claims 1 through 6 for a full body nuclear spin tomograph with a shim and gradient system for the production of magnetic correction and gradient fields in three orthogonal spatial directions, characterized in that, measured in the field length direction, the opening extent of a transverse access opening feeding into the investigational volume (V), assumes a value of at least 45 cm.

8. Magnet system according to claim 7, characterized in that at least one entrance opening is provided for which runs transverse to the body axis of the patient and which is usable for the arrangement or for the effecting of means for monitoring, diagnosing or providing therapy to the patient or for communication with the patient.

9. Magnet system according to one of the preceding claims characterized in that the homogeneity region has a diameter, with a field deviation of at most ± 20 ppm, of at least 40 % of the smaller of the axial separations g₂ or g₁ (g₂) of the inner (2a, 2b) or outer coil pair respectively.

10. Magnet system according to claim 9, characterized in that the homogeneity region has a diameter of at least 50 % of the cited dimension.

## Revendications

1. Système magnétique pour produire un champ magnétique statique homogène dans le volume d'étude d'un tomographe à résonance magnétique nucléaire, système comportant une paire de bobines de champ (1a, 1b), radialement extérieures et identiques entre elles, disposées sur un axe commun (a) à une distance, mesurée selon la direction axiale, (g₁) l'une de l'autre, et comportant aussi une paire de bobines de champ (2a, 2b), radialement intérieures, coaxiales avec les bobines de champ extérieures, également identiques entre elles, système dans lequel les deux paires de bobines sont disposées symétriquement par rapport à un plan médian central (E) orienté perpendiculairement à l'axe commun (a) et dans lequel, lorsque le système magnétique (10) est en fonctionnement, le sens du courant dans les bobines de champ intérieures (2a et 2b) est orienté à l'opposé de celui passant dans les bobines de champ extérieures (1a et 1b), système comportant au moins une ouverture d'accès conduisant au volume d'étude, système caractérisé par le fait que la distance, mesurée selon la direction axiale, (g₁) des bobines de champ extérieures (1a et 1b) vaut 40% à 60% du diamètre intérieur (da₂) des bobines de champ extérieures (1A et 1b), par le fait que la distance, mesurée selon la direction axiale, (g₂) des bobines de champ intérieures (2a et 2b) est égale, avec un écart d'au maximum 15%, à la distance, mesurée selon la direction axiale, (g₁) des bobines de champ extérieures (1a et 1b), par le fait que le système magnétique forme un système de bobines qui est au moins largement du huitième ordre, et par le fait qu'est prévue au moins une ouverture d'accès radiale qui s'étend transversalement à la direction du champ magnétique homogène et passe entre les bobines de champ intérieures (2a, 2b).

2. Système magnétique selon la revendication 1, caractérisé par une ouverture d'accès axiale qui s'étend selon la direction du champ magnétique homogène.

3. Système magnétique selon l'une des revendications précédentes, caractérisé par le fait que pour le retour du flux magnétique est prévu,à l'extérieur, un écran de fer entourant au moins par tronçons, vu selon la direction périphérique, le système de bobines de champ (1a, 1b, 2a, 2b), par le fait que l'écran de fer présente une enveloppe tubulaire entourant le système de bobines (1a, 1b, 2a, 2b) et par le fait que cette enveloppe présente au moins un évidement dont le passage libre longitudinal, mesuré parallèlement à l'axe central (a) et le passage libre azimutal, mesuré perpendiculairement au précédent, sont déterminés par les dimensions correspondantes d'une ouverture d'accès transversale du système magnétique (10).

4. Système magnétique selon la revendication 3, caractérisé par le fait que l'écran de fer comprend des éléments d'écran en forme de longerons qui s'étendent parallèlement à l'axe central (a) du système de bobines (1a, 1b, 2a, 2b) et dont la distance, mesurée selon la direction périphérique, est déterminée par le passage libre des ouvertures d'accès transversales.

5. Système magnétique selon la revendication 3 ou 4, caractérisé par le fait que l'écran de fer présente des parois frontales extrêmes en forme de disque annulaire.

6. Système magnétique selon la revendication 3 ou 4, caractérisé par le fait que l'écran de fer présente des plaques d'extrémité fermées.

7. Système magnétique selon l'une des revendications précédentes 1 à 6 pour un tomographe à résonance magnétique nucléaire pour le corps entier, présentant un système de compensation et de gradients pour produire des champs magnétiques correcteurs et à gradients selon les trois dimensions orthogonales de l'espace, système caractérisé par le fait que le passage libre, mesuré selon la direction longitudinale du champ, d'une ouverture transversale d'accès débouchant dans le volume d'étude (V) a au moins 45 cm.

8. Système magnétique selon la revendication 7, caractérisé par le fait qu'est prévue au moins une ouverture d'accès qui est orientée transversalement à l'axe du corps du patient et qui peut s'utiliser pour disposer ou laisser passer des moyens pour la surveillance, le diagnostic ou la thérapie du patient ou pour la communication avec le patient.

9. Système magnétique selon l'une des revendications précédentes, caractérisé par le fait que le domaine d'homogénéité présentant un écart de champ d'au maximum ± 20 ppm a un diamètre d'au moins 40% de la plus petite distance, mesurée selon la direction axiale, g₂ ou g₁ (g₂) de la paire de bobines intérieure (2a , 2b) ou extérieure.

10. Système magnétique selon la revendication 9, caractérisé par le fait que le domaine d'homogénéité a un diamètre d'au moins 50% de la dimension mentionnée.
